# EUROPEAN PATENT SPECIFICATION

(11) **EP 4 271 154 B1**
(45) Date of publication and mention of the grant of the patent: **28.01.2026**
(21) Application number: 23164511.0
(22) Date of filing: 28.03.2023
(51) Int. Cl.: H05K 7/20

(54) **POWER HOST AND POWER SUPPLY SYSTEM**
STROMHOST UND STROMVERSORGUNGSSYSTEM
HÔTE D'ALIMENTATION ET SYSTÈME D'ALIMENTATION ÉLECTRIQUE

(30) Priority: 29.04.2022 CN 202210467480
(43) Date of publication of application: 01.11.2023
(73) Proprietor: Huawei Digital Power Technologies Co., Ltd., Shenzhen, Guangdong 518043 (CN)
(72) Inventor: LIU, Jihui, Shenzhen, 518043 (CN); WEI, Longhe, Shenzhen, 518043 (CN); LIAN, Zhisheng, Shenzhen, 518043 (CN)
(74) Representative: Isarpatent

(56) References cited:
- WO-A1-2019/146099
- CN-A- 107 804 211
- CN-U- 204 555 445
- CN-U- 213 238 035
- CN-U- 215 453 752
- JP-A- 2014 163 530
- US-A1- 2015 237 767
- US-A1- 2020 363 136

## Description

### TECHNICAL FIELD

This application relates to the field of new energy technologies, and in particular, to a power host and a power supply system.

### BACKGROUND

Heat is generated in a running process of a power host. Therefore, heat dissipation performance of the power host is a key indicator for normal running and a service life of the power host. For example, a charging host of a new energy vehicle supplies power to one or more charging terminals, and the charging host needs to have good heat dissipation performance.

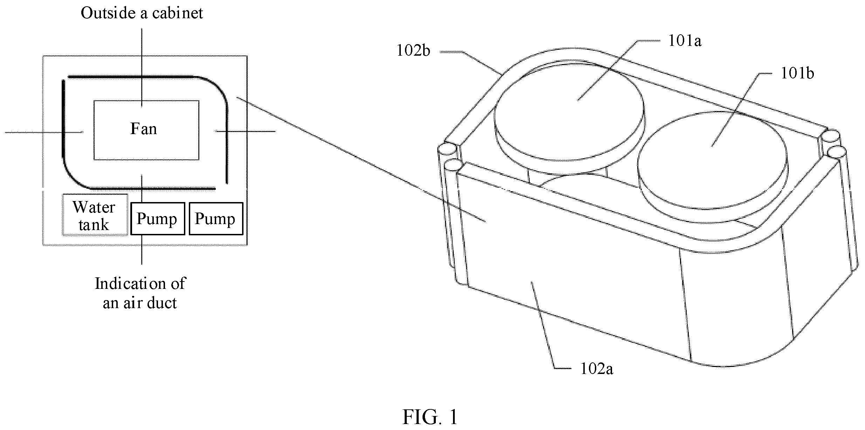

FIG. 1 is a schematic three-dimensional diagram of a heat dissipation apparatus in an existing power host and a schematic diagram of an air duct. Currently, the heat dissipation apparatus in the power host includes an air-liquid heat exchanger and one or more fans (for example, a fan 101a and a fan 101b in FIG. 1) that are mounted on a top of a power apparatus. The air-liquid heat exchanger is connected to the power apparatus by using a pipeline, and heat on the power apparatus is dissipated by using the air-liquid heat exchanger.

In FIG. 1, the air-liquid heat exchanger includes two "L"-shaped heat exchange fins (a heat exchange fin 102a and a heat exchange fin 102b). However, FIG. 1 is a schematic diagram of an air duct of an "L"-shaped heat exchanger. Air intake volumes on a long side and a short side of the "L"-shaped heat exchanger are different, and consequently, uneven air intake on the heat exchanger is caused, and heat dissipation performance is poor.

In view of this, heat dissipation performance of the power host needs to be improved urgently.

CN 215 453 752 U discloses a water-cooling frequency conversion cabinet.

JP 2014 163530 A discloses an air conditioning apparatus.

CN 107 804 211 A discloses an air conditioner outdoor unit and a shelter vehicle.

CN 213 238 035 U discloses a machine room cooling unit integrated with a fluorine pump.

WO 2019/146099 A1 discloses an air conditioning device.

CN 204 555 445 U discloses an air cooling screw set condenser structure.

US 2020/363136 A1 discloses an adaptive condensing device for a dual-loop heat pipe air conditioner.

US 2015/237767 A1 discloses a heat sink for cooling a heat source which includes a thermally conductive base member configured to mount on, or be placed in thermal communication with, a heat source.

### SUMMARY

This application provides a power host and a power supply system, as defined in the appended set of claims, to improve heat dissipation performance of the power host.

Air intake on the two heat exchange fins of the first heat exchanger is even, and the two heat exchange fins are disposed obliquely relative to a housing of the power apparatus, so that a heat dissipation area is increased, and overall heat dissipation efficiency of the power host is improved. In addition, the first spacing between the second side edge and the fourth side edge is greater than a second spacing between the first side edge and the second side edge, and this facilitates mounting of a pump and the like.

In a possible implementation, the first heat exchange fin and the second heat exchange fin form a "V"-shaped architecture.

In this implementation, the two heat exchange fins form the "V"-shaped architecture. Compared with existing heat exchange fins in an "L"-shaped architecture, the heat exchange fins in the "V"-shaped architecture have even air intake, so that heat dissipation efficiency can be improved. In addition, the existing heat exchange fins in the "L"-shaped architecture occupy large space, and parallel placement or mounting against a wall is limited, but it is convenient to mount the heat exchange fins in the "V"-shaped architecture against a wall, so that space can be saved.

In another possible implementation, the liquid receiver is located between the first heat exchange fin and the second heat exchange fin, on an outer side of the first heat exchange fin, or on an outer side of the second heat exchange fin.

In this implementation, the liquid receiver is located between the first heat exchange fin and the second heat exchange fin, on the outer side of the first heat exchange fin, or on the outer side of the second heat exchange fin, and this helps save space.

In still another possible implementation, a temperature sensor is disposed inside the liquid receiver, and the temperature sensor is configured to detect temperature of a thermally conductive medium in the liquid receiver.

In this implementation, the sensor can accurately detect the temperature of the thermally conductive medium in the liquid receiver, and accurately learn heat dissipation performance.

In still another possible implementation, the first pipe includes a water inlet pipe and a water outlet pipe, a first pipeline is formed between the water inlet pipe and the water outlet pipe by using a first pump and a first check valve, and a second pipeline is formed between the water inlet pipe and the water outlet pipe by using a second pump and a second check valve; the first check valve is configured to disable water flow in the first pipeline when the first pump fails; and the second check valve is configured to disable water flow in the second pipeline when the second pump fails.

In this implementation, compared with a dual pump system used for temperature control of an existing power host, a temperature control and heat dissipation capability of an entire system decreases to less than 20% after a single pump fails. In this implementation, one check valve is disposed on each pipeline, and when a pump fails, water flow in the pipeline is disabled, so that the temperature control and heat dissipation capability of the entire system is not significantly reduced.

In still another possible implementation, one or more air vents are disposed on the first heat exchange fin and the second heat exchange fin; and air enters through the one or more air vents on the first heat exchange fin and/or the second heat exchange fin, passes through the one or more first fans, and goes out from a top of the one or more first fans; or air enters from a top of the one or more first fans, and goes out through the one or more air vents on the first heat exchange fin and/or the second heat exchange fin.

In this implementation, an air duct design is improved, and a heat dissipation capability is improved.

In still another possible implementation, the power apparatus includes a power distribution unit, a part that is of the housing and that is configured to enclose the power distribution unit forms a power distribution compartment, a second heat exchanger is disposed in the power distribution compartment, and a pipeline of the second heat exchanger is connected to a pipeline of the first heat exchanger.

In this implementation, compared with an existing power distribution unit that uses natural heat dissipation, in this implementation, the second heat exchanger is disposed, and the pipeline of the second heat exchanger is connected to the pipeline of the first heat exchanger, so that a heat dissipation capability of the power distribution unit is improved with a small variation.

In still another possible implementation, one or more second fans are disposed in the power distribution compartment, and the second fan is configured to dissipate heat for the power distribution compartment.

In this implementation, compared with an existing power distribution unit that uses natural heat dissipation, in this implementation, the fan is further disposed in the power distribution compartment, so that the heat dissipation capability of the power distribution unit is further improved.

### BRIEF DESCRIPTION OF DRAWINGS

FIG. 1 is a schematic three-dimensional diagram of and a schematic diagram of an air duct of a heat dissipation apparatus in an existing power host;
FIG. 2 is a schematic three-dimensional diagram of a power host according to an embodiment of this application;
FIG. 3 is a schematic diagram of an internal structure of a power host according to an embodiment of this application;
FIG. 4 is a schematic cross-sectional diagram of a power host according to an embodiment of this application;
FIG. 5 is a schematic diagram of a dual pump system in an existing heat dissipation apparatus;
FIG. 6 is a schematic diagram of an example after an existing single pump fails;
FIG. 7 is a schematic three-dimensional diagram of a dual pump system according to an embodiment of this application;
FIG. 8 is a schematic diagram obtained after a single pump fails according to an embodiment of this application;
FIG. 9 is a schematic diagram of an air duct according to an embodiment of this application;
FIG. 10 is a schematic diagram of another air duct according to an embodiment of this application; and
FIG. 11 is a schematic diagram of a structure of a power supply system according to an embodiment of this application.

### DESCRIPTION OF EMBODIMENTS

The following describes embodiments of this application with reference to the accompanying drawings in embodiments of this application.

A power host in embodiments of this application is a machine or a device that can output power to one or more power terminals. The power host may be, for example, a charging host of a new energy vehicle. The charging host may supply power to charging terminals of one or more new energy vehicles.

Embodiments of this application provide a power host and a power supply system. Air intake on two heat exchange fins of a first heat exchanger (heat exchanger) in the power host is even, and the two heat exchange fins are disposed obliquely relative to a housing of a power apparatus, so that a heat dissipation area is increased, and overall heat dissipation efficiency of the power host is improved.

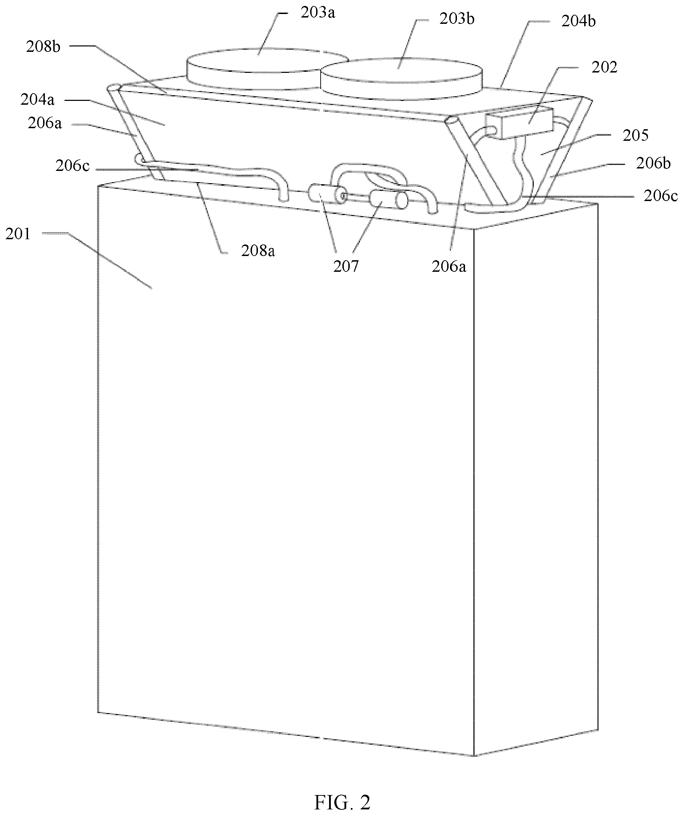

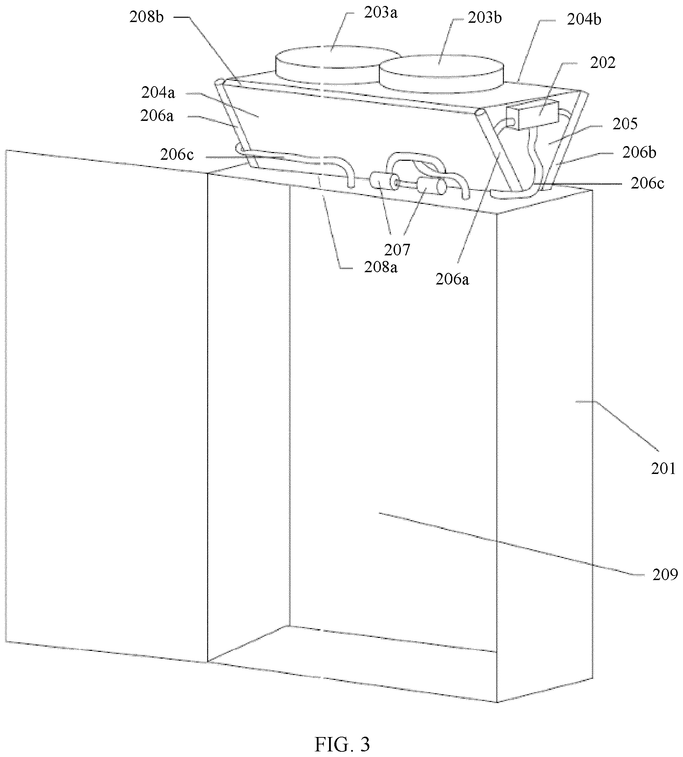

FIG. 2 is a schematic three-dimensional diagram of a power host according to an embodiment of this application. The power host includes a housing 201, a power apparatus (not shown in the figure) disposed inside the housing 201, and a heat dissipation apparatus. The housing 201 may be a housing of any material, for example, a stainless steel housing or a plastic housing, and is mainly configured to protect the power apparatus from external damage. The power apparatus includes a plurality of electronic components, modules, and the like that generate and output power. FIG. 3 is a schematic diagram of an internal structure of a power host according to an embodiment of this application. A housing 201 forms enclosure space 209, and a plurality of electronic components, modules, and the like in a power apparatus may be placed in the enclosure space 209.

A heat dissipation apparatus is configured to dissipate heat for the power apparatus. The heat dissipation apparatus includes a first heat exchanger and one or more first fans (two fans are shown in the figure: a fan 203a and a fan 203b, and a quantity of fans is not limited in this embodiment). The heat dissipation apparatus may dissipate heat in an air cooling or liquid cooling manner. When the heat dissipation apparatus dissipates heat in the liquid cooling manner, the heat dissipation apparatus may further include a liquid receiver 202. The fan may be another entity that can dissipate heat.

The first heat exchanger includes a first heat exchange fin 204a and a second heat exchange fin 204b. The first heat exchange fin 204a and the second heat exchange fin 204b are disposed on a same outer surface of the housing 201, and are respectively disposed obliquely relative to the housing 201. The first heat exchange fin 204a and the second heat exchange fin 204b have accommodation space 205. The first heat exchange fin 204a includes a first side edge 208a and a second side edge 208b, the second heat exchange fin 204b includes a third side edge and a fourth side edge, the first side edge 208a of the first heat exchange fin 204a and the third side edge of the second heat exchange fin 204b are fastened on a surface of the housing 201, and the first side edge 208a of the first heat exchange fin 204a is isolated from the third side edge of the second heat exchange fin 204b, a first spacing between the second side edge 208b of the first heat exchange fin 204a and the fourth side edge of the second heat exchange fin 204b is greater than a second spacing between the first side edge 208a of the first heat exchange fin 204a and the third side edge of the second heat exchange fin 204b. Because the first heat exchange fin 204a and the second heat exchange fin 204b are respectively disposed obliquely relative to the housing 201, heat dissipation areas of the first heat exchange fin 204a and the second heat exchange fin 204b are increased, and this helps improve heat dissipation efficiency.

For example, one or more air vents are disposed on the first heat exchange fin and the second heat exchange fin.

The first heat exchange fin 204a further includes a fifth side edge and a sixth side edge, and the second heat exchange fin further includes a seventh side edge and an eighth side edge. The fifth side edge is adjacent to the seventh side edge, and the sixth side edge is adjacent to the eighth side edge. As described above, the first heat exchange fin 204a and the second heat exchange fin 204b are disposed on the same outer surface of the housing. If the outer surface that is of the housing and that bears the first heat exchange fin 204a and the second heat exchange fin 204b is used as a reference, both the fifth side edge and the seventh side edge are close to one end of the outer surface, and both the sixth side edge and the eighth side edge are close to the other end of the outer surface.

In addition to the first heat exchange fin 204a and the second heat exchange fin 204b, the first heat exchanger further includes a pipe. A first pipe 206a is disposed on the fifth side edge and/or the sixth side edge of the first heat exchange fin 204a, and a second pipe 206b is disposed on the seventh side edge and/or the eighth side edge of the second heat exchange fin 204b. The first heat exchanger is further connected to a liquid receiver 202 and the power apparatus by using a third pipe 206c.

Further, in a possible implementation, an extension direction of the first pipe 206a is the same as an extension direction of the fifth side edge, and the first pipe 206a is located on an outer side of the fifth side edge or is in contact with the fifth side edge; and an extension direction of the second pipe 206b is the same as an extension direction of the seventh side edge, and the second pipe 206b is located on an outer side of the seventh side edge or is in contact with the seventh side edge.

In another possible implementation, an extension direction of the first pipe 206a is the same as an extension direction of the sixth side edge, and the first pipe 206a is located on an outer side of the sixth side edge or is in contact with the sixth side edge; and an extension direction of the second pipe 206b is the same as an extension direction of the eighth side edge, and the second pipe 206b is located on an outer side of the eighth side edge or is in contact with the eighth side edge.

The liquid receiver 202 is configured to store a thermally conductive medium. The thermally conductive medium is a medium used to conduct heat, and the thermally conductive medium may also be referred to as a thermally conductive working medium. For example, the thermally conductive medium may be thermally conductive liquid such as water. The liquid receiver 202 is connected to the first pipe 206a on the first heat exchange fin 204a, the second pipe 206b on the second heat exchange fin 204b, and a pump 207 by using the third pipe 206c.

The fan 203a and the fan 203b may be disposed in a plurality of implementations. At least a part of the fan 203a and the fan 203b is located in the accommodation space 205. In an example, the fan 203a and the fan 203b may be entirely located in the accommodation space 205. In other words, the fan 203a and the fan 203b may be located in the accommodation space 205 without extending out of the accommodation space 205. In another example, the fan 203a and the fan 203b may alternatively be partially located in the accommodation space 205. In other words, the fan 203a and the fan 203b may partially extend out of the accommodation space 205, to better dissipate heat for thermally conductive mediums in the first pipe 206a and the second pipe 206b.

A working principle of the heat dissipation apparatus is that the thermally conductive medium inside the first pipe 206a circulates in the first pipe 206a under the action of the pump 207. The thermally conductive medium conducts heat on the power apparatus to the thermally conductive medium, and the thermally conductive medium is heated. The thermally conductive medium is conducted to the first pipe 206a and/or the second pipe 206b under the action of the pump 207. The thermally conductive medium in the first pipe 206a and/or the second pipe 206b cools under the action of the fan 203a and/or the fan 203b. The cooled thermally conductive medium is transmitted to the liquid receiver 202 under the action of the pump 207. Under the action of the pump 207, the thermally conductive medium in the liquid receiver 202 is conducted again to a pipe that is of the first heat exchanger and that extends into the power apparatus. Heat is dissipated for the power apparatus in such a cycle.

In the foregoing solution, the two heat exchange fins of the first heat exchanger do not have a long side or a short side. Therefore, air intake on the two heat exchange fins of the first heat exchanger is even, and the two heat exchange fins are disposed obliquely relative to the housing of the power apparatus, so that a heat dissipation area is increased, and overall heat dissipation efficiency of the power host is improved.

In addition, the existing "L"-shaped heat exchanger shown in FIG. 1 occupies large space, and mounting against a wall is limited. By contrast, in this embodiment, use of the foregoing solution can facilitate mounting against a wall and save space.

The first spacing is greater than the second spacing; in other words, in a stacking direction of the heat dissipation apparatus and the power apparatus, the accommodation space is in a structure with a small lower surface and a large upper surface. In this way, mounting can be facilitated. For example, mounting of the liquid receiver 202 in the heat dissipation apparatus, the pump 207, the first pipe 206a, and the second pipe 206b can be facilitated.

Further, the first heat exchange fin 204a and the second heat exchange fin 204b form a "V"-shaped architecture. In this example, the two heat exchange fins form the "V"-shaped architecture. Compared with existing heat exchange fins in an "L"-shaped architecture, the heat exchange fins in the "V"-shaped architecture have even air intake, so that heat dissipation efficiency can be improved. In addition, the existing heat exchange fins in the "L"-shaped architecture occupy large space, and parallel placement or mounting against a wall is limited, but it is convenient to mount the heat exchange fins in the "V"-shaped architecture against a wall, so that space can be saved.

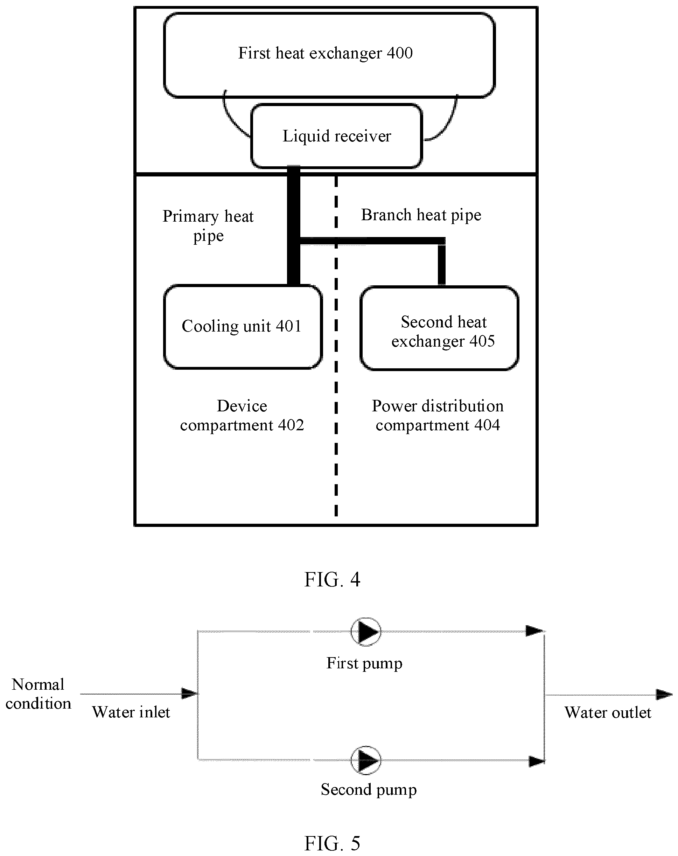

FIG. 4 is a schematic cross-sectional diagram of a power host according to an embodiment of this application. A power apparatus includes a power unit (not shown in the figure) and a cooling unit 401. The power unit is located on the cooling unit 401. A housing that encloses the power unit and the cooling unit forms a device compartment 402. The cooling unit 401 is connected to a first heat exchanger 400 by using a third pipe 206c. The cooling unit 401 is configured to dissipate heat for the power unit. For example, the cooling unit 401 may be a cold plate.

The first heat exchanger may be connected to a liquid receiver 202 and the power apparatus in the following two manners:
In one manner, a first pipe 206a includes one or more first outlets, and a second pipe 206b includes one or more second outlets. One first outlet of the first pipe 206a and one second outlet of the second pipe 206b are separately connected to an inlet of the liquid receiver 202, and an outlet of the liquid receiver 202 is connected to the cooling unit 401 by using a pump 207. The cooling unit 401 conducts heat of the power unit to the first pipe 206a and/or the second pipe 206b. Under the action of the pump 207, a thermally conductive medium in the first pipe 206a and/or the second pipe 206b is transmitted to the first pipe 206a and the second pipe 206b. The thermally conductive medium in the first pipe 206a and/or the second pipe 206b dissipates heat under the action of a fan 203a and/or a fan 203b. A cooled thermally conductive medium in the first pipe 206a is transmitted to the liquid receiver 202 through the one or more first outlets under the action of the pump. Similarly, a cooled thermally conductive medium in the second pipe 206b is also transmitted to the liquid receiver 202 through the one or more second outlets under the action of the pump. Under the action of the pump 207, a thermally conductive medium in the liquid receiver 202 is re-transmitted to a pipe connected to the cooling unit 401.

In this manner, the liquid receiver 202 is equivalent to a three-way pipeline member. An existing heat dissipation apparatus needs to be linked by using a plurality of three-way pipeline members, a structure of the heat dissipation apparatus is complex, a pipe has a long size, large space is occupied, and costs are high. By contrast, in this embodiment, use of the three-way pipeline members is reduced, and costs are reduced. In addition, another first outlet of the first pipe 206a and another second outlet of the second pipe 206b may be connected to the pump 207 by using the three-way pipeline member.

In the other manner, a first pipe 206a includes one or more first inlets, and a second pipe 206b includes one or more second inlets. One first inlet of the first pipe 206a and one second inlet of the second pipe 206b are separately connected to an outlet of the liquid receiver 202, and an inlet of the liquid receiver 202 is connected to the cooling unit. The cooling unit 401 conducts heat of the power unit to the first pipe 206a and/or the second pipe 206b. Under the action of the pump 207, a thermally conductive medium in the first pipe 206a and/or the second pipe 206b is transmitted to the liquid receiver 202. A thermally conductive medium in the liquid receiver 202 is transmitted to the first pipe 206a and/or the second pipe 206b under the action of the pump 207. The thermally conductive medium in the first pipe 206a and/or the second pipe 206b dissipates heat under the action of a fan 203a and/or a fan 203b. A cooled thermally conductive medium in the first pipe 206a and/or the second pipe 206b is re-transmitted to a pipe connected to the cooling unit 401.

In this manner, the liquid receiver 202 is equivalent to a three-way pipeline member. An existing heat dissipation apparatus needs to be linked by using a plurality of three-way pipeline members, a structure of the heat dissipation apparatus is complex, a pipe has a long size, large space is occupied, and costs are high. By contrast, in this embodiment, use of the three-way pipeline members is reduced, and costs are reduced. In addition, another first inlet of the first pipe 206a and another second inlet of the second pipe 206b may be connected to the pump 207 by using the three-way pipeline member.

A location of the liquid receiver 202 is not limited in this embodiment. The following placement manners are available:
In one manner, the liquid receiver 202 may be located on an outer side of the first heat exchange fin 204a or an outer side of the second heat exchange fin 204b, and this helps save space.

In another manner, the liquid receiver 202 may be located between the first heat exchange fin 204a and the second heat exchange fin 204b.

Further, a temperature sensor may be further disposed inside the liquid receiver 202 or on a surface of the liquid receiver 202. The temperature sensor is configured to detect temperature of the thermally conductive medium in the liquid receiver 202. The temperature sensor can accurately detect the temperature of the thermally conductive medium in the liquid receiver 202, and accurately learn heat dissipation performance.

The heat dissipation apparatus in this application may use a single pump system, or may use a dual pump system. Output power and a volume of a pump in the single pump system are large.

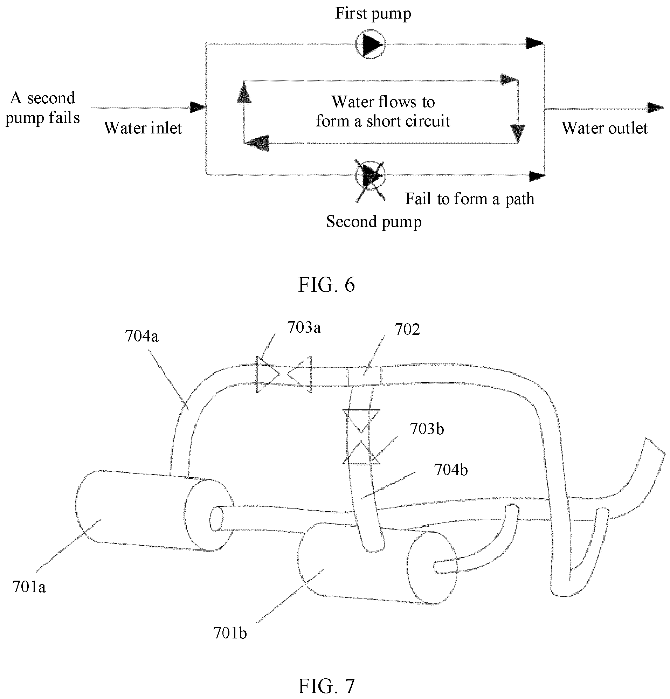

In addition, when the heat dissipation apparatus uses the dual pump system, FIG. 5 is a schematic diagram of a dual pump system in an existing heat dissipation apparatus. The dual pump system includes a first pump and a second pump. In a normal case, water entering the dual pump system can be quickly discharged under the action of the first pump and the second pump, and water outlet efficiency is improved. However, after a single pump fails, a heat dissipation capability of the entire power host decreases to less than 20%. FIG. 6 is a schematic diagram of an example after an existing single pump fails. After the second pump fails, a pipe in which the second pump is located forms a path, and under the action of a single first pump, water flows to form a short circuit, and a water flow rate is significantly reduced and a heat dissipation capability of the entire power host is reduced.

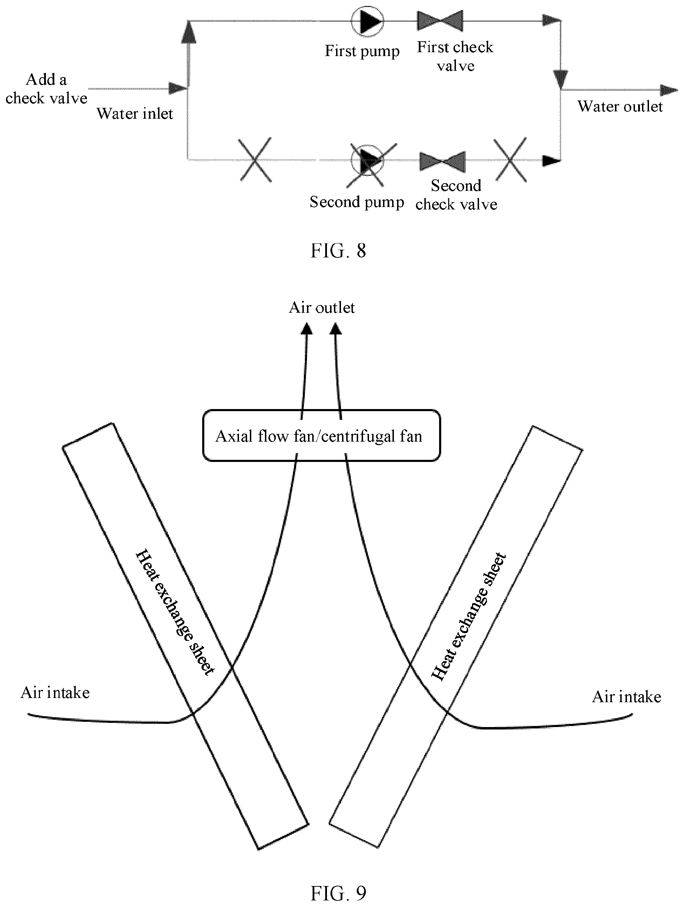

FIG. 7 is a schematic three-dimensional diagram of a dual pump system according to an embodiment of this application. The heat dissipation apparatus in FIG. 2 may use the dual pump system. The dual pump system includes a first pump 701a and a second pump 701b. Water inlets of the first pump 701a and the second pump 701b are connected by using a three-way pipeline member 702. Water outlets of the first pump 701a and the second pump 701b may also be connected by using a three-way pipeline member (not shown in the figure). A first heat exchanger includes a water inlet pipe and a water outlet pipe, a pipe 704a is formed between the water inlet pipe and the water outlet pipe by using the first pump 701a and a first check valve 703a, and a pipe 704b is formed between the water inlet pipe and the water outlet pipe by using the second pump 701b and a second check valve 703b. The first check valve 703a is configured to disable water flow in the pipe 704a when the first pump 701a fails, and the second check valve 703b is configured to disable water flow in the pipe 704b when the second pump 701b fails. FIG. 8 is a schematic diagram obtained after a single pump fails according to an embodiment of this application. It is assumed that the second pump 701b fails, the second check valve 703b disables the water flow in the pipe 704b, the pipe 704b does not form a path, and water flow does not cause a short circuit. A check principle when the first pump 701a fails is similar to this. Compared with a dual pump system used for temperature control of an existing power host, a temperature control and heat dissipation capability of an entire system decreases to less than 20% after a single pump fails. In this example, one check valve is disposed on each pipe, and when a pump fails, water flow in the pipe is disabled, so that the temperature control and heat dissipation capability of the entire system is not significantly reduced.

Further, in this embodiment, the fan 203a and the fan 203b shown in FIG. 2 may have the following two heat dissipation manners:
FIG. 9 is a schematic diagram of an air duct according to an embodiment of this application. In one manner, air enters through the one or more air vents of the first heat exchange fin 204a and/or the second heat exchange fin 204b, passes through the fan 203a and/or the fan 203b, and goes out from a top of the fan 203a and the fan 203b.

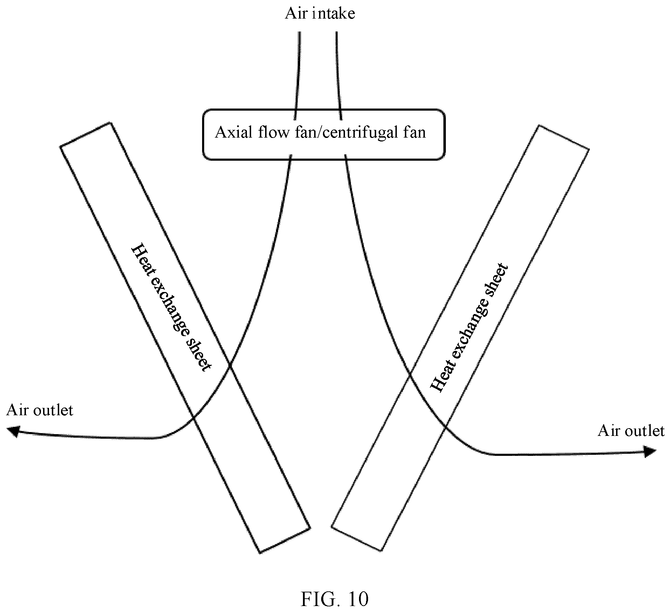

FIG. 10 is a schematic diagram of another air duct according to an embodiment of this application. In the other manner, air enters from a top of the fan 203a and/or the fan 203b, and goes out through the one or more air vents of the first heat exchange fin 204a and/or the second heat exchange fin 204b.

In this embodiment, an air duct design is improved, and a heat dissipation capability is improved.

For example, the fan 203a and the fan 203b may be axial flow fans or centrifugal fans. When the axial flow fan works, blades push air to flow in a same direction as an axis, and therefore the fan is referred to as the axial flow fan. Axial flow fans are classified into a large axial flow fan, a medium axial flow fan, and a small axial flow fan. An appropriate axial flow fan is selected based on a required use place. The centrifugal fan sucks fluid from an axial direction of the fan and then uses centrifugal force to push the fluid out from a circumference.

Still as shown in FIG. 4, the power apparatus may further include a power distribution unit. A part that is of the housing and that is configured to enclose the power distribution unit forms a power distribution compartment 404. In a conventional technology, the power distribution compartment uses a natural heat dissipation manner. However, when the power distribution compartment is fully loaded with output (that is, all power terminals need to output power to a load), local temperature rises, and there may be a problem that a cold point is prone to condensation in a local part in a high-humidity environment.

In this embodiment, heat of the power distribution compartment 404 may be dissipated in the following manners:
In one manner, as shown in FIG. 4, a second heat exchanger 405 is disposed in the power distribution compartment 404. A pipe of the second heat exchanger 405 is connected to the pipe of the first heat exchanger 400. A pipe that connects the cooling unit 401 to the first heat exchanger 400 may be referred to as a primary pipe, and a pipe that connects the second heat exchanger 405 to the first heat exchanger 400 may be referred to as a branch pipe. A manner in which the second heat exchanger 405 exchanges heat for the power distribution compartment 404 is similar to a principle of the first heat exchanger 400, and details are not described herein again. Compared with an existing power distribution compartment that uses natural heat dissipation, in this embodiment, the second heat exchanger is disposed, and the pipe of the second heat exchanger is connected to the pipe of the first heat exchanger, so that a heat dissipation capability of the power distribution compartment is improved with a small variation.

In another manner, one or more second fans are disposed in the power distribution compartment 404, and the second fan is configured to dissipate heat for the power distribution compartment 404. The second fan may be an axial flow fan or a centrifugal fan. Compared with an existing power distribution compartment that uses natural heat dissipation, in this implementation, the fan is further disposed in the power distribution compartment, so that a heat dissipation capability of the power distribution compartment can be improved.

In still another manner, a second heat exchanger 405 is disposed in the power distribution compartment 404, and one or more second fans are disposed. In other words, the foregoing two manners are combined. The heat dissipation capability of the power distribution compartment can be further improved.

The second heat exchanger 405 is located in the power distribution compartment 404. Therefore, a model or a size of the second heat exchanger 405 may be smaller than that of the first heat exchanger 400.

In conclusion, according to the power host provided in this embodiment of this application, air intake on the two heat exchange fins of the first heat exchanger is even, and the two heat exchange fins are disposed obliquely relative to the housing of the power apparatus, so that a heat dissipation area is increased, and overall heat dissipation efficiency of the power host is improved.

In addition, the existing "L"-shaped heat exchanger shown in FIG. 1 occupies large space, and mounting against a wall is limited. By contrast, in this embodiment, use of the foregoing solution can facilitate mounting against a wall and save space.

One check valve is disposed on each pipe connected to the pump, and when a pump fails, water flow in the pipe is disabled, so that a temperature control and heat dissipation capability of the entire system is not significantly reduced.

The second heat exchanger and/or the one or more second fans are disposed for the power distribution compartment, so that a heat dissipation capability of the power distribution compartment is improved.

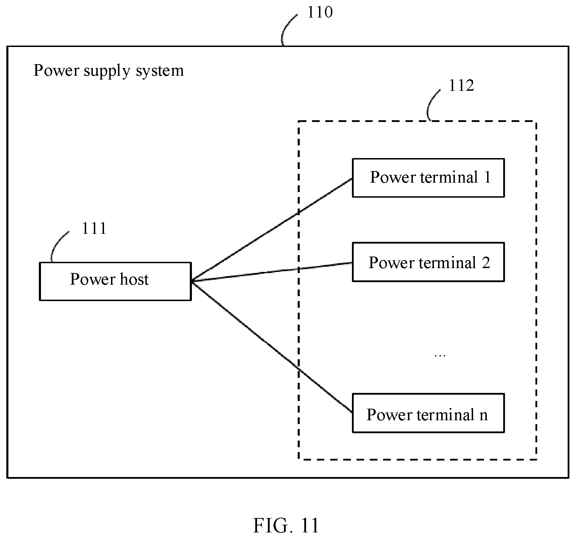

As shown in FIG. 11, an embodiment of this application further provides a power supply system 110 including a power host 111 and one or more power terminals 112 (n power terminals are shown in the figure). The power host 111 is configured to output power to the one or more power terminals 112. The power host 111 may be the power host in the foregoing embodiment.

First, second, third, fourth, and various numbers in embodiments of this application are differentiated for ease of description, and are not intended to limit the scope of this application.

In embodiments of this application, "at least one" means one or more, and "a plurality of" means two or more. "At least two" means two or more. "And/or" describes an association relationship between associated objects and represents that three relationships may exist. For example, A and/or B may represent the following cases: Only A exists, both A and B exist, and only B exists, where A and B may be singular or plural. In text descriptions of embodiments of this application, a character "/" generally indicates an "or" relationship between associated objects.

In the foregoing embodiments, the description of each embodiment has respective focuses. For a part that is not described in detail in an embodiment, refer to related descriptions in other embodiments.

Components in the apparatus in embodiments of this application may be combined, divided, and deleted based on an actual requirement. A person skilled in the art may combine different embodiments or features of different embodiments described in this specification.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

The foregoing embodiments are merely used to describe the technical solutions of this application, but not to limit this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A power host (111), wherein the power host (111) comprises a housing (201), a power apparatus disposed inside the housing (201), and a heat dissipation apparatus, the heat dissipation apparatus comprises a first heat exchanger (400) and one or more first fans (203a, 203b), the first heat exchanger (400) comprises a first heat exchange fin (204a) and a second heat exchange fin (204b), the first heat exchange fin (204a) and the second heat exchange fin (204b) are disposed on a same outer surface of the housing (201) and each are disposed obliquely relative to the housing (201), the first heat exchange fin (204a) and the second heat exchange fin (204b) form an accommodation space (205) in between them, the first heat exchange fin (204a) comprises a first side edge (208a) and a second side edge (208b), the second heat exchange fin (204b) comprises a third side edge and a fourth side edge, the first side edge (208a) and the third side edge are fastened on a surface of the housing (201), the first side edge (208a) is isolated from the third side edge, and a first spacing between the second side edge (208b) and the fourth side edge is greater than a second spacing between the first side edge (208a) and the third side edge;
at least a part of the one or more first fans (203a, 203b) are located in the accommodation space (205);
the first heat exchanger (400) is thermally connected to the power apparatus, and the first heat exchanger (400) is configured to exchange heat with the power apparatus; and
the one or more first fans (203a, 203b) are configured to dissipate heat from the first heat exchanger (400),
wherein the heat dissipation apparatus further comprises a liquid receiver (202) and a pump (207), the power apparatus comprises a power unit and a cooling unit (401), the first heat exchange fin (204a) further comprises a fifth side edge and a sixth side edge, the second heat exchange fin (204b) further comprises a seventh side edge and an eighth side edge, a first pipe (206a) is disposed on the fifth side edge and/or the sixth side edge of the first heat exchange fin (204a), and a second pipe (206b) is disposed on the seventh side edge and/or the eighth side edge of the second heat exchange fin (204b); and
the first pipe (206a) comprises a first outlet and a first inlet, the second pipe (206b) comprises a second outlet and a second inlet, wherein the cooling unit (401) is configured to conduct heat of the power unit to the first inlet of the first pipe (206a) and/or the second inlet of the second pipe (206b), the first outlet on the first pipe (206a) and the second outlet on the second pipe (206b) are each connected to separate inlets of the liquid receiver (202), and an outlet of the liquid receiver (202) is connected to a pipe connected to the cooling unit (401) such that a thermally conductive medium in the liquid receiver (202), under an action of the pump (207), is re-transmitted to the cooling unit (401); or
wherein an inlet of the liquid receiver (202) is connected to the cooling unit (401), such that a thermally conductive medium in the liquid receiver (202) is transmitted to the first inlet of the first pipe (206a) and/or the second inlet of the second pipe (206b) under an action of the pump (207), wherein the first inlet on the first pipe (206a) and the second inlet on the second pipe (206b) are each connected to separate outlets of the liquid receiver (202).

2. The power host according to claim 1, wherein the first heat exchange fin and the second heat exchange fin form a "V"-shaped architecture.

3. The power host according to claim 1, wherein the liquid receiver is located between the first heat exchange fin and the second heat exchange fin, on an outer side of the first heat exchange fin, or on an outer side of the second heat exchange fin.

4. The power host according to claim 1 or 3, wherein a sensor is disposed inside the liquid receiver, and the sensor is configured to detect temperature of a thermally conductive medium in the liquid receiver.

5. The power host according to any one of claims 1 to 4, wherein the first pipe comprises a water inlet pipe and a water outlet pipe, a first pipeline is formed between the water inlet pipe and the water outlet pipe by using a first pump (701a) and a first check valve (703a), and a second pipeline is formed between the water inlet pipe and the water outlet pipe by using a second pump (701b) and a second check valve (703b);
the first check valve (703a) is configured to disable water flow in the first pipeline when the first pump (701a) fails; and
the second check valve (703b) is configured to disable water flow in the second pipeline when the second pump (701b) fails.

6. The power host according to any one of claims 1 to 5, wherein one or more air vents are disposed on the first heat exchange fin and the second heat exchange fin; and
air enters through the one or more air vents on the first heat exchange fin and/or the second heat exchange fin, passes through the one or more first fans, and goes out from a top of the one or more first fans; or
air enters from a top of the one or more first fans, and goes out through the one or more air vents on the first heat exchange fin and/or the second heat exchange fin.

7. The power host according to any one of claims 1 to 6, wherein the one or more first fans are axial flow fans or centrifugal fans.

8. The power host according to any one of claims 1 to 7, wherein the power apparatus comprises a power distribution unit, a part that is of the housing and that is configured to enclose the power distribution unit forms a power distribution compartment (404), a second heat exchanger (405) is disposed in the power distribution compartment (404), and a pipeline of the second heat exchanger (405) is connected to a pipeline of the first heat exchanger.

9. The power host according to any one of claims 1 to 8, wherein one or more second fans are disposed in the power distribution compartment, and the second fan is configured to dissipate heat for the power distribution compartment.

10. A power supply system (110), comprising the power host (111) according to any one of claims 1 to 9 and one or more power terminals (112), wherein
the power host (111) is configured to output power to the one or more power terminals (112).

## Patentansprüche

1. Stromhost (111), wobei der Stromhost (111) ein Gehäuse (201), eine im Inneren des Gehäuses (201) angeordnete Stromvorrichtung und eine Wärmeableitungsvorrichtung umfasst, die Wärmeableitungsvorrichtung einen ersten Wärmetauscher (400) und einen oder mehrere erste Lüfter (203a, 203b) umfasst, der erste Wärmetauscher (400) ein erstes Wärmetauschableitblech (204a) und ein zweites Wärmetauschableitblech (204b) umfasst, das erste Wärmetauschableitblech (204a) und das zweite Wärmetauschableitblech (204b) auf derselben Außenfläche des Gehäuses (201) angeordnet sind und jeweils schräg relativ zu dem Gehäuse (201) angeordnet sind, das erste Wärmetauschableitblech (204a) und das zweite Wärmetauschableitblech (204b) zwischen sich einen Aufnahmeraum (205) ausbilden, das erste Wärmetauschableitblech (204a) eine erste Seitenkante (208a) und eine zweite Seitenkante (208b) umfasst, das zweite Wärmetauschableitblech (204b) eine dritte Seitenkante und eine vierte Seitenkante umfasst, die erste Seitenkante (208a) und die dritte Seitenkante an einer Oberfläche des Gehäuses (201) befestigt sind, die erste Seitenkante (208a) von der dritten Seitenkante isoliert ist und ein erster Abstand zwischen der zweiten Seitenkante (208b) und der vierten Seitenkante größer als ein zweiter Abstand zwischen der ersten Seitenkante (208a) und der dritten Seitenkante ist;
sich mindestens ein Teil des einen oder der mehreren ersten Lüfter (203a, 203b) in dem Aufnahmeraum (205) befindet;
der erste Wärmetauscher (400) thermisch mit der Stromvorrichtung verbunden ist und der erste Wärmetauscher (400) dazu konfiguriert ist, Wärme mit der Stromvorrichtung auszutauschen; und
der eine oder die mehreren ersten Lüfter (203a, 203b) dazu konfiguriert sind, Wärme aus dem ersten Wärmetauscher (400) abzuleiten,
wobei die Wärmeableitungsvorrichtung ferner einen Flüssigkeitsbehälter (202) und eine Pumpe (207) umfasst, die Stromvorrichtung eine Antriebseinheit und eine Kühleinheit (401) umfasst, das erste Wärmeaustauschableitblech (204a) ferner eine fünfte Seitenkante und eine sechste Seitenkante umfasst, das zweite Wärmeaustauschableitblech (204b) ferner eine siebte Seitenkante und eine achte Seitenkante umfasst, ein erstes Rohr (206a) auf der fünften Seitenkante und/oder der sechsten Seitenkante des ersten Wärmeaustauschableitblechs (204a) angeordnet ist und ein zweites Rohr (206b) auf der siebten Seitenkante und/oder der achten Seitenkante des zweiten Wärmeaustauschableitblechs (204b) angeordnet ist; und
das erste Rohr (206a) einen ersten Auslass und einen ersten Einlass umfasst, das zweite Rohr (206b) einen zweiten Auslass und einen zweiten Einlass umfasst, wobei die Kühleinheit (401) dazu konfiguriert ist, Wärme der Antriebseinheit an den ersten Einlass des ersten Rohrs (206a) und/oder den zweiten Einlass des zweiten Rohrs (206b) zu leiten, der erste Auslass an dem ersten Rohr (206a) und der zweite Auslass an dem zweiten Rohr (206b) jeweils mit separaten Einlässen des Flüssigkeitsbehälters (202) verbunden sind, und ein Auslass des Flüssigkeitsbehälters (202) mit einem Rohr verbunden ist, das derart mit der Kühleinheit (401) verbunden ist, dass ein wärmeleitendes Medium in dem Flüssigkeitsbehälter (202) unter einer Betätigung der Pumpe (207) an die Kühleinheit (401) zurückgeführt wird; oder
wobei ein Einlass des Flüssigkeitsbehälters (202) derart mit der Kühleinheit (401) verbunden ist, dass ein wärmeleitendes Medium in dem Flüssigkeitsbehälter (202) unter einer Betätigung der Pumpe (207) zu dem ersten Einlass des ersten Rohrs (206a) und/oder dem zweiten Einlass des zweiten Rohrs (206b) geleitet wird, wobei der erste Einlass an dem ersten Rohr (206a) und der zweite Einlass an dem zweiten Rohr (206b) jeweils mit separaten Auslässen des Flüssigkeitsbehälters (202) verbunden sind.

2. Stromhost nach Anspruch 1, wobei das erste Wärmeaustauschableitblech und das zweite Wärmeaustauschableitblech eine V-förmige Architektur ausbilden.

3. Stromhost nach Anspruch 1, wobei sich der Flüssigkeitsbehälter zwischen dem ersten Wärmeaustauschableitblech und dem zweiten Wärmeaustauschableitblech, auf einer Außenseite des ersten Wärmeaustauschableitblechs oder auf einer Außenseite des zweiten Wärmeaustauschableitblechs befindet.

4. Stromhost nach Anspruch 1 oder 3, wobei ein Sensor im Inneren des Flüssigkeitsbehälters angeordnet ist und der Sensor dazu konfiguriert ist, die Temperatur eines wärmeleitenden Mediums in dem Flüssigkeitsbehälter zu erfassen.

5. Stromhost nach einem der Ansprüche 1 bis 4, wobei das erste Rohr ein Wassereinlassrohr und ein Wasserauslassrohr umfasst, eine erste Rohrleitung zwischen dem Wassereinlassrohr und dem Wasserauslassrohr unter Verwendung einer ersten Pumpe (701a) und eines ersten Rückschlagventils (703a) ausgebildet ist und eine zweite Rohrleitung zwischen dem Wassereinlassrohr und dem Wasserauslassrohr unter Verwendung einer zweiten Pumpe (701b) und eines zweiten Rückschlagventils (703b) ausgebildet ist;
das erste Rückschlagventil (703a) dazu konfiguriert ist, den Wasserfluss in der ersten Rohrleitung zu unterbrechen, wenn die erste Pumpe (701a) ausfällt; und
das zweite Rückschlagventil (703b) dazu konfiguriert ist, den Wasserfluss in der zweiten Rohrleitung zu unterbrechen, wenn die zweite Pumpe (701b) ausfällt.

6. Stromhost nach einem der Ansprüche 1 bis 5, wobei eine oder mehrere Entlüftungsöffnungen an dem ersten Wärmeaustauschableitblech und dem zweiten Wärmeaustauschableitblech angeordnet sind; und
Luft durch die eine oder die mehreren Lüftungsöffnungen an dem ersten Wärmetauschableitblech und/oder dem zweiten Wärmetauschableitblech einströmt, durch den einen oder die mehreren ersten Lüfter strömt und an einer Oberseite des einen oder der mehreren ersten Lüfter austritt; oder
Luft von einer Oberseite des einen oder der mehreren ersten Lüfter einströmt und durch die eine oder die mehreren Lüftungsöffnungen an dem ersten Wärmeaustauschableitblech und/oder dem zweiten Wärmeaustauschableitblech austritt.

7. Stromhost nach einem der Ansprüche 1 bis 6, wobei der eine oder die mehreren ersten Lüfter Axiallüfter oder Radiallüfter sind.

8. Stromhost nach einem der Ansprüche 1 bis 7, wobei die Stromvorrichtung eine Stromverteilungseinheit umfasst, ein Teil, der von dem Gehäuse stammt und der dazu konfiguriert ist, die Stromverteilungseinheit einzuhausen, ein Stromverteilungsfach (404) ausbildet, ein zweiter Wärmetauscher (405) in dem Stromverteilungsfach (404) angeordnet ist und eine Rohrleitung des zweiten Wärmetauschers (405) mit einer Rohrleitung des ersten Wärmetauschers verbunden ist.

9. Stromhost nach einem der Ansprüche 1 bis 8, wobei ein oder mehrere zweite Lüfter in dem Stromverteilungsfach angeordnet sind und der zweite Lüfter dazu konfiguriert ist, Wärme für das Stromverteilungsfach abzuleiten.

10. Stromversorgungssystem (110), umfassend den Stromhost (111) nach einem der Ansprüche 1 bis 9 und einen oder mehrere Stromanschlüsse (112), wobei
der Stromhost (111) dazu konfiguriert ist, Strom an den einen oder die mehreren Stromanschlüsse (112) auszugeben.

## Revendications

1. Hôte d'alimentation (111), dans lequel l'hôte d'alimentation (111) comprend un boîtier (201), un appareil d'alimentation disposé à l'intérieur du boîtier (201) et un appareil de dissipation thermique, l'appareil de dissipation thermique comprend un premier échangeur thermique (400) et un ou plusieurs premiers ventilateurs (203a, 203b), le premier échangeur thermique (400) comprend une première ailette d'échange thermique (204a) et une seconde ailette d'échange thermique (204b), la première ailette d'échange thermique (204a) et la seconde ailette d'échange thermique (204b) sont disposées sur une même surface extérieure du boîtier (201) et chacune sont disposées obliquement par rapport au boîtier (201), la première ailette d'échange thermique (204a) et la seconde ailette d'échange thermique (204b) forment un espace de logement (205) entre elles, la première ailette d'échange thermique (204a) comprend un premier bord latéral (208a) et un deuxième bord latéral (208b), la seconde ailette d'échange thermique (204b) comprend un troisième bord latéral et un quatrième bord latéral, le premier bord latéral (208a) et le troisième bord latéral sont fixés sur une surface du boîtier (201), le premier bord latéral (208a) est isolé du troisième bord latéral, et un premier espacement entre le deuxième bord latéral (208b) et le quatrième bord latéral est supérieur à un second espacement entre le premier bord latéral (208a) et le troisième bord latéral ;
au moins une partie des un ou plusieurs premiers ventilateurs (203a, 203b) sont situés dans l'espace de logement (205) ;
le premier échangeur thermique (400) est connecté thermiquement à l'appareil d'alimentation, et le premier échangeur thermique (400) est configuré pour échanger de la chaleur avec l'appareil d'alimentation ; et
les un ou plusieurs premiers ventilateurs (203a, 203b) sont configurés pour dissiper la chaleur du premier échangeur thermique (400),
dans lequel l'appareil de dissipation thermique comprend également un récepteur de liquide (202) et une pompe (207), l'appareil d'alimentation comprend une unité d'alimentation et une unité de refroidissement (401), la première ailette d'échange thermique (204a) comprend également un cinquième bord latéral et un sixième bord latéral, la seconde ailette d'échange thermique (204b) comprend également un septième bord latéral et un huitième bord latéral, un premier tuyau (206a) est disposé sur le cinquième bord latéral et/ou le sixième bord latéral de la première ailette d'échange thermique (204a), et un second tuyau (206b) est disposé sur le septième bord latéral et/ou le huitième bord latéral de la seconde ailette d'échange thermique (204b) ; et
le premier tuyau (206a) comprend une première sortie et une première entrée, le second tuyau (206b) comprend une seconde sortie et une seconde entrée, dans lequel l'unité de refroidissement (401) est configurée pour conduire la chaleur de l'unité d'alimentation vers la première entrée du premier tuyau (206a) et/ou la seconde entrée du second tuyau (206b), la première sortie du premier tuyau (206a) et la seconde sortie du second tuyau (206b) sont chacune connectées à des entrées distinctes du récepteur de liquide (202), et une sortie du récepteur de liquide (202) est connectée à un tuyau connecté à l'unité de refroidissement (401) de sorte qu'un fluide thermoconducteur présent dans le récepteur de liquide (202), sous l'action de la pompe (207), soit retransmis à l'unité de refroidissement (401) ; ou
dans lequel une entrée du récepteur de liquide (202) est connectée à l'unité de refroidissement (401), de sorte qu'un fluide thermoconducteur dans le récepteur de liquide (202) soit transmis à la première entrée du premier tuyau (206a) et/ou à la seconde entrée du second tuyau (206b) sous l'action de la pompe (207), dans lequel la première entrée du premier tuyau (206a) et la seconde entrée du second tuyau (206b) sont chacune connectées à des sorties séparées du récepteur de liquide (202).

2. Hôte d'alimentation selon la revendication 1, dans lequel la première ailette d'échange thermique et la seconde ailette d'échange thermique forment une architecture en forme de « V ».

3. Hôte d'alimentation selon la revendication 1, dans lequel le récepteur de liquide est situé entre la première ailette d'échange thermique et la seconde ailette d'échange thermique, sur un côté extérieur de la première ailette d'échange thermique, ou sur un côté extérieur de la seconde ailette d'échange thermique.

4. Hôte d'alimentation selon la revendication 1 ou 3, dans lequel un capteur est disposé à l'intérieur du récepteur de liquide, et le capteur est configuré pour détecter la température d'un fluide thermoconducteur dans le récepteur de liquide.

5. Hôte d'alimentation selon l'une quelconque des revendications 1 à 4, dans lequel le premier tuyau comprend un tuyau d'entrée d'eau et un tuyau de sortie d'eau, une première canalisation est formée entre le tuyau d'entrée d'eau et le tuyau de sortie d'eau à l'aide d'une première pompe (701a) et d'un premier clapet anti-retour (703a), et une seconde canalisation est formée entre le tuyau d'entrée d'eau et le tuyau de sortie d'eau à l'aide d'une seconde pompe (701b) et d'un second clapet anti-retour (703b) ;
le premier clapet anti-retour (703a) est configuré pour désactiver le débit d'eau dans la première canalisation lorsque la première pompe (701a) tombe en panne ; et
le second clapet anti-retour (703b) est configuré pour désactiver le débit d'eau dans la seconde canalisation lorsque la seconde pompe (701b) tombe en panne.

6. Hôte d'alimentation selon l'une quelconque des revendications 1 à 5, dans lequel une ou plusieurs ouvertures d'aération sont disposées sur la première ailette d'échange thermique et la seconde ailette d'échange thermique ; et
l'air entre par les une ou plusieurs ouvertures d'aération de la première ailette d'échange thermique et/ou de la seconde ailette d'échange thermique, traverse les un ou plusieurs premiers ventilateurs et sort par le haut des un ou plusieurs premiers ventilateurs ; ou
l'air entre par le haut des un ou plusieurs premiers ventilateurs et sort par les une ou plusieurs ouvertures d'aération de la première ailette d'échange thermique et/ou de la seconde ailette d'échange thermique.

7. Hôte d'alimentation selon l'une quelconque des revendications 1 à 6, dans lequel les un ou plusieurs premiers ventilateurs sont des ventilateurs à flux axial ou des ventilateurs centrifuges.

8. Hôte d'alimentation selon l'une quelconque des revendications 1 à 7, dans lequel l'appareil d'alimentation comprend une unité de distribution d'alimentation, une partie du boîtier et qui est configurée pour enfermer l'unité de distribution d'alimentation forme un compartiment de distribution d'alimentation (404), un second échangeur thermique (405) est disposé dans le compartiment de distribution d'alimentation (404), et une canalisation du second échangeur thermique (405) est connectée à une canalisation du premier échangeur thermique.

9. Hôte d'alimentation selon l'une quelconque des revendications 1 à 8, dans lequel un ou plusieurs seconds ventilateurs sont disposés dans le compartiment de distribution d'alimentation, et le second ventilateur est configuré pour dissiper la chaleur pour le compartiment de distribution d'alimentation.

10. Système d'alimentation électrique (110), comprenant l'hôte d'alimentation (111) selon l'une quelconque des revendications 1 à 9 et une ou plusieurs bornes d'alimentation (112), dans lequel l'hôte d'alimentation (111) est configuré pour alimenter les une ou plusieurs bornes d'alimentation (112).
